# EUROPÄISCHE PATENTANMELDUNG

(11) **EP 0 947 847 A2**
(43) Veröffentlichungstag der Anmeldung: **06.10.1999**
(21) Anmeldenummer: 99103976.9
(22) Anmeldetag: 10.03.1999
(51) Int. Cl.: G01R 33/30

(54) **Halterung zur Untersuchung von Objekten mittels mikroskopischer in viro MR-Bildgebung**

(30) Priorität: 01.04.1998 DE 19814674
(71) Anmelder: GSF-Forschungszentrum für Umwelt und Gesundheit, GmbH, 85764 Oberschleissheim (DE)
(72) Erfinder: Griebel, Jürgen, Dr., 82049 Pullach (DE); Brandl, Matthias, Dr., 97531 Buch (DE); Dellian, Mark, Dr., 80801 München (DE); Goetz, Alwin, Dr., 81477 München (DE); Pahernik, Sascha, Dr., 82152 Krailling (DE)
(74) Vertreter: Reinhard - Skuhra - Weise & Partner

(57) **Zusammenfassung**

Eine Anordnung zur Untersuchung von Objekten, insbesondere mit flacher Geometrie, mit einer Sonde mit einer Halteeinrichtung für eine Objekthalterung, ist in einen etwa zylindrischen Hohlraum eines MR-Magneten einsetzbar. Die Objekthalterung weist einen Schlitz zur Durchführung einer Testkammer auf. Die Testkammer besteht aus zwei geringfügig zueinander beabstandeten Platten aus Kunststoff, zwischen welchen eine zu testende Gewebestruktur oder dergleichen eingesetzt ist. Die Testkammer weist einen Testbereich bzw. ein Testauge vorbestimmter Größe bzw. Fläche auf. Die Testkammer wird zwischen zwei zueinander beabstandeten, konzentrischen und parallelen Spulenabschnitten einer HF-Spule eingesetzt, derart, daß der Testbereich etwa konzentrisch zu der HF-Spule zwischen den Spulenabschnitten zu liegen kommt. Die Größe und/oder Fläche jedes Spulenabschnitts der HF-Spule entspricht weitgehend der Größe und/oder Fläche des Testbereichs, und die HF-Spule ist an ein MR-System angeschlossen.

## Beschreibung

Die Erfindung betrifft eine Anordnung zur Untersuchung von Objekten, insbesondere biologischen Objekten wie Gewebestrukturen, mit flacher Geometrie.

Ein tiefergehendes Verständnis von morphometrischen und funktionellen Befunden der MR-Bildgebung ist ohne die Kenntnis der (patho)histologischen und (patho)physiologischen Zusammenhänge in den untersuchten Gewebestrukturen nicht möglich. Eine Korrelation zwischen in vivo MR-Bildgebung und Referenztechniken, die Aussagen über Histologie und Physiologie in der mit MR untersuchten Gewebestruktur ermöglichen, ist unter den oben genannten Bedingungen derzeit nicht möglich.

Die derzeit eingesetzten in vivo Referenztechniken zur histologischen und physiologischen Gewebecharaktersierung (Laserdopplertechnik, polarographische Sauerstoffmessung, Near Infrared Spektroskopie, konfokale Laserscanningmikroskopie) haben allesamt den Nachteil, daß sie sog. Sondentechniken sind, d.h., daß sie immer nur ein ganz beschränktes Areal innerhalb des Gewebes untersuchen können. Um eine räumlich differenzierte Information über die gesamte Gewebestruktur zu erhalten, ist es deshalb notwendig, den Meßvorgang an verschiedenen Positionen innerhalb des Gewebes zu wiederholen, was ohne spezielle Präparationstechniken immer mit einer räumlichen Unsicherheit verbunden ist. Nachteile sind weiterhin, daß die angesprochenen Techniken entweder die gewebliche Integrität verletzten und damit invasiv sind (Laserdopplertechnik, polarographische Sauerstoffmessung), daß sie eine schlechte räumliche Auflösung haben (Near Infrared Spektroskopie: mm3-Bereich) oder daß sie nur eine sehr beschrankte Eindringtiefe in das Gewebe besitzen und damit nur die meist nicht repräsentativen peripheren Gewebeanteile erfassen können (konfokale Laser-scanningmikroskopie: max. ca. 100 mm Eindringtiefe).

Ein alternativer Ansatz versucht die geschilderten Schwierigkeiten der in vivo Referenztechniken zu vermeiden und verwendet für die histologische bzw. physiologische Gewebecharakterisierung ex vivo Referenztechniken (histologische Färbungstechniken, autoradiographische Techniken, Lumineszenztechniken). Zur Korrelation werden die Gewebestrukturen unmittelbar nach den MR-Untersuchungen entnommen und weiterverarbeitet (Schockgefrieren in flüssigem Stickstoff, histologische Fixation, Erstellen von Feinschnitten). Allen diesen Verfahren ist gemeinsam, daß es durch die jeweilige Weiterverarbeitung zu Verformungen und Verzerrungen der Gewebestrukturen kommt, so daß - zusätzlich zum Nachteil der ex vivo Technik - eine sichere Zuordnung der gewonnenen Ergebnisse mit der MR-Bildgebung nicht mehr möglich ist.

Der Erfindung liegt die Aufgabe zugrunde, eine Anordnung zur Untersuchung von insbesondere biologischen Objekten zu schaffen, die sowohl eine in vivo MR-Bildgebung als auch eine Intravitalmikroskopie an einem biologischen Objekt erlaubt.

Diese Aufgabe wird erfindungsgemäß durch die im Patentanspruch 1 angegebenen Merkmale gelöst.

Weitere Ausgestaltungen der Erfindung ergeben sich aus den Unteransprüchen.

Die Erfindung schafft eine Anordnung zur Untersuchung von Objekten, mit welcher eine räumlich hoch aufgelöste Darstellung des vorzugsweise biologischen Objekts im Submillimeterbereich mittels in vivo MR-Bildgebung sowie eine räumlich hoch genaue Zuordnung von in vivo MR-Bildgebung und Intravitalmikroskopie möglich ist.

Die erfindungsgemäße Anordnung erfüllt die oben genannte Aufgabe dadurch, daß unter in vivo Bedingungen eine Gewebestruktur eines Versuchstiers in den Testbereich einer Testkammer mit flacher Geometrie eingebracht wird. Gemäß einer bevorzugten Ausführungsform ist die Testkammer in Form einer transparenten Rückenhautkammer ausgeführt. Durch die Erfindung wird es möglich, die Gewebestruktur im Testbereich der Testkammer mit der Technik der mikroskopischen in vivo MR-Bildgebung zu untersuchen. Durch die Ausführungsform der Testkammer in Form einer transparenten Rückenhautkammer wird es weiterhin erfindungsgemäß ermöglicht, die im Testbereich der Testkammer enthaltene Gewebestruktur - ohne weitere Manipulationen - sowohl mit der Technik der MR-Bildgebung als auch mit der Technik der Intravitalmikroskopie zu untersuchen.

Die mikroskopische in vivo MR-Bildgebung der Gewebestruktur innerhalb der Testkammer wird dadurch ermöglicht, daß die Testkammer mit ihrem Testbereich zwischen zwei parallel ausgerichteten Spulenabschnitte angeordnet wird, wobei die Spulenabschnitte etwa so groß sind wie und formmäßig angepaßt sind an die Fläche des Testbereichs. Nach dem an sich bekannten Prinzip der MR-Bildgebung bzw. -Spektroskopie werden die Spulenabschnitte mit der Testkammer in ein äußeres statisches Magnetfeld verbracht und dienen dort zur Anregung der Kernspins im Gewebe innerhalb des Testbereichs durch Einstrahlung von HF-Pulsen und zur Detektion der HF-Antwortsignale der Atomkerne. Die Antwortsignale werden dann im MR-System aufgenommen und weiterverarbeitet, wodurch spektroskopische und räumliche Informationen über die angeregten Atomkerne im Gewebe gewonnen werden. Die für die mikroskopische MR-Bildgebung erforderliche hohe Anforderung an die Sensitivität der MR-Detektion wird somit erfindungsgemäß dadurch erreicht, daß ein für den Testbereich der Testkammer optimiertes Spulendesign angewendet wird. Die Sensitivität der MR-Detektion wird weiterhin gesteigert durch die Anwendung von starken und besonders homogenen äußeren Magnetfeldern. Das mit der erfindungsgemäßen Anordnung erreichte sehr hohe Signal-zu-Rausch-Verhältnis, mit dem die Gewebestrukturen in der Testkammer erfaßt werden, erlaubt es, diese Strukturen mittels in vivo MR-Bildgebung nichtinvasiv mit hoher räumlicher (Submillimeterbereich) und zeitlicher (Subsekundenbereich) Auflösung darzustellen und sowohl morphometrisch als auch funktionell zu charakterisieren.

Der Einsatz der Intravitalmikroskopie, die an sich bekannt ist, erlaubt die nichtinvasive Darstellung von histologischen Strukturen und physiologischen Prozessen in den Gewebestrukturen im Testbereich der Testkammer von der geweblichen bis zur zellulären Ebene. An Hand von markanten Leitstrukturen im Gewebe (z.B. Blutgefäßen etc.) bzw. mittels geeigneter Marker, die sowohl in der MR- als auch der Intravitalmikroskopie sichtbar sind, wird eine räumlich hochgenaue Zuordnung von in vivo MR-Mikroskopie und Intravitalmikroskopie gewährleistet. Erfindungsgemäß wird hierdurch eine nichtinvasive und intravitale Korrelation von morphologischen und funktionellen MR-Befunden mit histologischen und physiologischen Informationen der Intravitalmikroskopie im Submillimeterbereich ermöglicht.

Die erfindungsgemäße Anordnung ist somit prädestiniert für die Entwicklung und Validierung von neuartigen MR-Techniken, wodurch die Voraussetzungen für die klinische Anwendung dieser Techniken geschaffen werden kann, sowie für die Anwendung auf biomedizinische Fragestellungen, deren Beantwortung nur durch die intravitale nichtinvasive Korrelation von Techniken der MR-Bildgebung sowie der Intravitalmikroskopie möglich ist bzw. dadurch wesentlich erleichtert und verbessert wird. Beispiele sind:
1) qualitative und quantitative Charakterisierung pharmakologischer Eigenschaften von MR-Kontrastmitteln in normalem und pathologischem Gewebe;
2) Entwicklung und Validierung geeigneter tracerkinetischer Modelle zur quantitativen Bestimmung von Parametern der Mikrozirkulation (z.B. Perfusion, Extrazellulärvolumen, Intravasalvolumen, Kapillarpermeabilität von nieder- und makromolekularen Substanzen) in normalem und pathologischem Gewebe mittels dynamischer MR-Kontrastmittelstudien;
3) Untersuchng des Einflusses von therapeutischen Maßnahmen auf Parenchym und Gefäßsystem im Gewebe;
4) Untersuchungen zum Transport von therapeutischen Substanzen im Gewebe, insbesondere im Rahmen einer Tumortherapie (Chemotherapie, Immuntherapie, Gentherapie);
5) Überwachung einer anti-angiogenetischen Therapie;
6) in vivo Erfassung der Akkumulation von MR-markierten Carriermolekülen (z.B. Liposomen) für gentherapeutische Konstrukte im Gewebe bzw. für Wirksubstanzen im Rahmen von transdermalen Applikationen; etc.

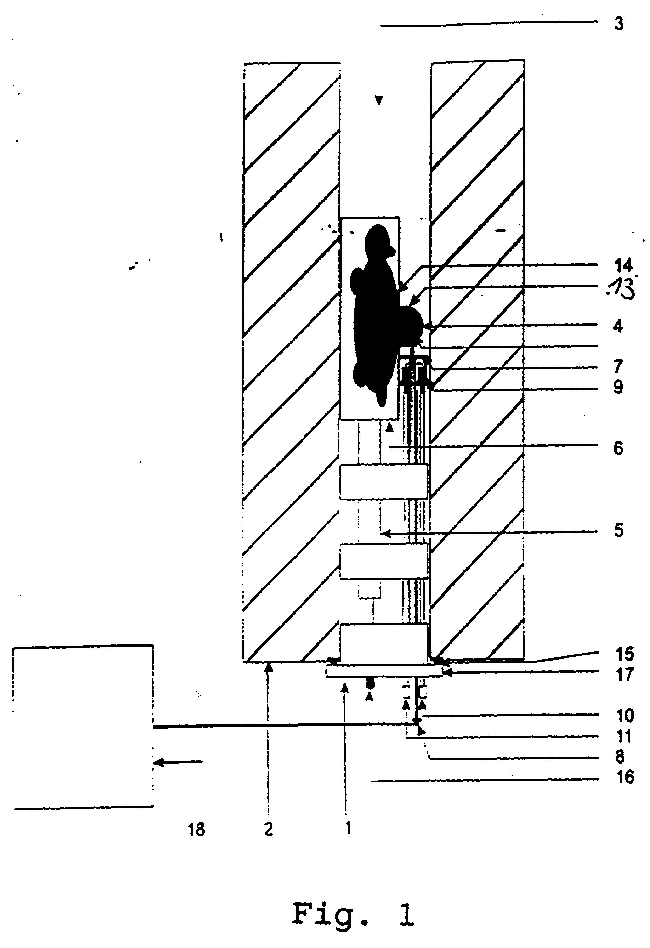

Die erfindungsgemäße Anordnung wird nachfolgend anhand der Zeichnung zur Erläuterung weiterer Merkmale und Vorteile beschrieben.

Die Zeichnung zeigt eine schematische Darstellung eines Teils der Anordnung und insbesondere der verwendeten MR-Mikroskopiesonde.

Die in der Zeichnung dargestellte Anordnung zur Untersuchung von Objekten, insbesondere mit flacher Geometrie, weist eine mit 1 bezeichnete MR-Mikroskopiesonde auf, die zum Zweck der Erzeugung eines MR-Bildes der untersuchten Gewebestruktur in den Hohlraum eines MR-Magneten 2 eingesetzt wird.

Prinzip der MR-Bildgebung und MR-Spektroskopie ist, aus der charakteristischen Energieaufspaltung von Atomkernen, die sich in einem äußeren Magnetfeld befinden, deren molekulare Umgebung zu erfassen. Hierzu müssen die Atomkerne zunächst durch HF-Einstrahlung energetisch angeregt werden. Die Rückkehr der angeregten Atome in das thermische Gleichgewicht geschieht durch Emission von HF-Strahlung, die detektiert und weiterverarbeitet wird. Anregung und Detektion kann über dieselbe, aber auch über zwei entkoppelte HF-Spulen stattfinden. Aufgrund der geringen Sensitivität der MR-Meßmethode, speziell bei kleinen Proben, sind optimal angepaßte HF-Spulen sowie hohe Energieaufspaltung durch starke Magnetfelder notwendig.

Der MR-Magnet ist in der Zeichnung teilweise dargestellt und durch das Bezugszeichen 2 angedeutet. Der Hohlraum des Magneten ist mit 3 bezeichnet, wobei der Hohlraum vorzugsweise zylindrisch ausgebildet ist. Der MR-Magnet hat beispielsweise eine Feldstärke von 9.4T (entspricht für Protonen einer Resonanzfrequenz von 400 MHz), der Durchmesser des Hohlraums 3 ist beispielsweise 89 mm.

Für die MR-Messung wird die MR-Mikroskopiesonde 1 in den Hohlraum 3 des MR-Magneten 2 eingeführt und über Befestigungsstifte 15 in der Abschlußplatte 17, die exakt in eine Befestigungsvorrichtung des MR-Magneten 2 passen, durch leichtes Verdrehen am MR-Magneten 2 fixiert.

Im einzelnen weist die MR-Mikroskopiesonde 1 eine Halteeinrichtung 5 auf, die eine Halterung 6 vorzugsweise verstellbar oder justierbar lagert. Die Halterung 6 ist beispielsweise schalenförmig ausgebildet zur Aufnahme eines Objektes, beispielsweise eines Tieres, wie dies nachfolgend noch beschrieben wird. Die Halteeinrichtung 5 sowie die Halterung 6 erlauben durch aufeinander abgestimmte Öffnungen die Applikation diverser Substanzen durch ein vorzugsweise zu- und abführendes Schlauchsystem. Dadurch wird beispielsweise eine Inhalationsnarkose sowie die Applikation von Kontrastmitteln an einem Tier in der Halterung 6 ermöglicht. Die Öffnungen sind zudem in der Abschlußplatteplatte 17 fortgesetzt, um eine Applikation während des Meßbetriebes der MR-Mikroskopiesonde im Magneten zu gewährleisten.

Zur Verstellung der Halterung 6 dient ein mit 16 bezeichneter Stellmechanismus, der eine Verschiebung der Halterung 6 in Achsenrichtung der MR-Mikroskopiesonde und damit eine Justierung des zu untersuchenden Objektes gegenüber der HF-Spule 4 ermöglicht.

Die HF-Spule 4 besteht aus zwei im wesentlichen parallelen und konzentrisch zueinander stehenden Spulenabschnitten, die in einer Helmholtzanordnung vorgesehen sind. Die Enden beider Spulenabschnitte sind zur Halterung 7 geführt und mit elektronischen Bauteilen, wie unmagnetische, feste und abstimmbare Kapazitäten 9 verbunden und über ein Koaxialkabel an einen mit 8 bezeichneten HF-Anschluß angeschlossen. Die mit dem Bezugszeichen 9 angedeuteten Kapazitäten sind durch mechanische Stellglieder abstimmbar. Die mechanischen Stellglieder sind mit 10 und 11 bezeichnet.

Aus vorstehender Beschreibung ergibt sich, daß die HF-Spule 4 gegenüber der Achse der MR-Mikroskopiesonde 1 versetzt ist. Sie ist außerhalb der Halterung 6 vorgesehen und steht in den Hohlraum 3 vor.

Die HF-Homogenität sowie Sensitivität zwischen dem eingeschlossenen Spulenvolumen sind erfindungsgemäß sehr hoch, wodurch die eingebrachten Testobjekte mit mikroskopischer Ortsauflösung bei hohem Signal-zu-Rausch Verhältnis innerhalb kurzer Meßzeit untersucht werden können. Die HF-Spule 4 wird sowohl im Sendemodus zur Anregung der Atomkerne als auch im Empfangsmodus zur sensitiven Detektion der von den Atomkernen ausgesandten HF-Strahlung betrieben.

Zur Anwendung der beschriebenen MR-Mikroskopiesonde 1 an verschiedenen Untersuchungsobjekten läßt sich die HF-Spule 4 so abstimmen, daß sie über einen breiten Tune- und Match-Bereich von beispielsweise 40 MHz bei 400 MHz Mittenfrequenz betrieben werden kann.

Die beiden parallelen und konzentrisch zueinander stehenden Spulenabschnitte der HF-Spule 4 haben einen Radius von vorzugsweise 10 mm, dem Testauge der Testkammer 13 angepaßt, und legen einen 5 mm breiten Spalt fest, in welchen eine schmale Testkammer 13 leicht einsetzbar ist.

Erfindungsgemäß können daher Objekte mit flacher Geometrie, deren Ausdehnung in zwei Dimensionen deutlich größer als die bei den üblichen MR-Mikroskopiespulen sind, mit MR-mikroskopischer Technik untersucht werden. Die an die Testkammer 13 angepaßte HF-Spule 4 kann somit Gewebe untersuchen, das in seiner Ausdehnung breiter als die Spulenflächen ist.

Für die erfindungsgemäße Anordnung ist wesentlich, daß die Testkammer 13 aus zwei dicht zueinander benachbarten, ein Gewebestruktur aufnehmenden Kunststoffwänden oder Kunststoffabschnitten besteht und ein Testauge bzw. einen Testbereich festlegt, dessen Größe soweit wie möglich auf die Form und Fläche der HF-Spule 4 abgestimmt ist. Bei der Gewebestruktur handelt es sich beispielsweise um die Rückenhaut eines Versuchstieres.

Die Testkammer 13 wird vor dem Einsetzen der Sonde 1 in den Magneten 2 durch einen in der Halterung 6 ausgebildeten Schlitz 14 hindurchgeführt, derart, daß die Testkammer 13 in den Spalt zwischen den beiden Spulenabschnitten der HF-Spule 4 eingesetzt wird. Durch Verstellen der der Halterung 6 über den Stellmechanismus 16 kann die Testkammer 13 so einjustiert bzw. verstellt werden, daß das Testauge genau konzentrisch gegenüber den Spulenabschnitten der HF-Spule 4 zu liegen kommt.

## Patentansprüche

1. Anordnung zur Untersuchung von Objekten, insbesondere mit flacher Geometrie, mit einer Sonde mit einer Halteeinrichtung für eine Objekthalterung, die in einem etwa zylindrischen Hohlraum eines MR-Magneten einsetzbar ist,
**dadurch gekennzeichnet,**
daß die Objekthalterung (3) einen Schlitz (14) zur Durchführung einer Testkammer (13) aufweist,
daß die Testkammer (13) aus zwei geringfügig zueinander beabstandeten Platten aus Kunststoff besteht, zwischen welchen eine zu testende Gewebestruktur oder dergleichen eingesetzt ist,
daß die Testkammer (13) einen Testbereich bzw. ein Testauge vorbestimmter Größe bzw. Fläche aufweist, wobei die Testkammer (13) zwischen zwei zueinander beabstandete, konzentrische und parallele Spulenabschnitte einer HF-Spule (4) eingesetzt wird, derart, daß der Testbereich etwa konzentrisch zu der HF-Spule (4) zwischen den Spulenabschnitten zu liegen kommt,
daß die Größe und/oder Fläche jedes Spulenabschnitts der HF-Spule weitgehend der Größe und/oder Fläche des Testbereichs entspricht, und
daß die HF-Spule (4) an ein MR-System (18) angeschlossen ist.

2. Anordnung nach einem der vorangehenden Ansprüche,
**dadurch gekennzeichnet,**
daß die Objekthalterung (6) im wesentlichen schalenförmig ausgestaltet ist.

3. Anordnung nach Anspruch 1 oder 2,
**dadurch gekennzeichnet,**
daß die HF-Spule (4) außeraxial zur Achse der Sonde (1) vorgesehen ist.

4. Anordnung nach einem der vorangehenden Ansprüche,
**dadurch gekennzeichnet,**
daß zumindest die Halterung (6) gegenüber der HF-Spule (4) verstellbar bzw. justierbar ist.

5. Anordnung nach wenigstens einem der vorangehenden Ansprüche,
**dadurch gekennzeichnet,**
daß die Spulenabschnitte der HF-Spule (4) gegenüber der Sonde (1) in Axialrichtung überstehen.

6. Anordnung nach wenigstens einem der vorangehenden Ansprüche,
**dadurch gekennzeichnet,**
daß die HF-Spule (4) mit Abstimmelementen, vorzugsweise Abstimmkondensatoren verbunden ist.

7. Anordnung nach wenigstens einem der vorangehenden Ansprüche,
**dadurch gekennzeichnet,**
daß eine Justier- bzw. Verstelleinrichtung (16) für die Objekthalterung (6) vorgesehen ist.

8. Anordnung nach wenigstens einem der vorangehenden Ansprüche,
**dadurch gekennzeichnet,**
daß die Testkammer (13) aus zwei zueinander parallen transparenten Kunststoffwänden besteht zur Aufnahme einer Gewebestruktur.

9. Anwendung der Anordnung nach wenigstens einem der vorangehenden Ansprüche zur Korrelation von morphometrischen und funktionellen Befunden der Magnetresonanz-Bildgebung mit (patho) histologischen und (patho) physiologischen Befunden der Intravitalmikroskopie - als Referenzmethode - an biologischen Objekten, insbesondere Gewebestrukturen, mit flacher Geometrie.
